# EUROPÄISCHE PATENTSCHRIFT

(11) **EP 4 384 755 B1**
(45) Veröffentlichungstag und Bekanntmachung des Hinweises auf die Patenterteilung: **02.07.2025**
(21) Anmeldenummer: 22740865.5
(22) Anmeldetag: 06.07.2022
(51) Int. Cl.: F24F 5/00, F24F 13/02, F24F 7/06, H05K 7/20, H05K 5/02

(54) **BELÜFTUNGS- UND KLIMATISIERUNGSSYSTEM**
VENTILATION AND AIR-CONDITIONING SYSTEM
SYSTÈME DE VENTILATION ET DE CLIMATISATION

(30) Priorität: 10.08.2021 DE 102021120799
(43) Veröffentlichungstag der Anmeldung: 19.06.2024
(73) Patentinhaber: Framatome GmbH, 91052 Erlangen (DE)
(72) Erfinder: DA SILVA WEBER, Christof, 91074 Herzogenaurach (DE); TRIEBEL, Nancy, 91056 Erlangen (DE)
(74) Vertreter: Lavoix
(86) Internationale Anmeldenummer: PCT/EP2022/068702
(87) Internationale Veröffentlichungsnummer: WO 2023/016710

(56) Entgegenhaltungen:
- EP-A1- 2 686 616
- ES-T3- 2 393 853
- GB-A- 2 568 043
- US-A1- 2009 126 293

## Beschreibung

Die vorliegende Erfindung betrifft ein Belüftungs- und Klimatisierungssystem für einen Raum.

Moderne Regelungs- und Steuerungskomponenten und -Anlagen, insbesondere in Kernkraftwerken, erzeugen eine stärke Wärmeabgabe durch Konvektion und Strahlung in den Technikraum, in dem sie installiert sind. Deswegen ist die Kühlung solcher Räume immer wichtiger geworden.

Normalerweise wird diese Kühlung durch ein aktives Belüftungs- und Klimatisierungssystem erreicht, das gekühlte Luft in den Technikraum bläst. Bei einem Ausfall der aktiven Kühlfunktion erreichen die im Raum vorhandenen Anlagen die maximal zulässige Temperatur jedoch typischerweise nach nur circa 2 Stunden.

Es ist, insbesondere aus der WO 2019/105559, bekannt, einen passiven Notkühlbetrieb vorzusehen, um die Zeit (im Folgenden als "Karenzzeit" bezeichnet), in der die im Raum vorhandenen Anlagen die maximal zulässige Temperatur erreichen, zum Beispiel auf bis zu 24 Stunden, zu erhöhen. Dies wird zum Beispiel durch das Vorsehen eines passiven Systems mit Phasenwechselmaterialien erreicht, das als Wärmespeicher wirkt.

Die Patentschrift EP 2 686 616 A1 zeigt ein Belüftungs- und Klimatisierungssystem mit den Merkmalen des Oberbegriffs von Anspruch 1.

Allerdings sind solche Systeme, insbesondere in Bezug auf deren Robustheit und Zuverlässigkeit, nicht ganz zufriedenstellend. In der Tat verwenden solche Systeme Zwischenteile, insbesondere zur Umschaltung vom aktiven auf den passiven Kühlbetrieb. Diese Zwischenteile können beschädigt werden, oder über längere Zeit im Standby ihre Funktion einbüßen, was die Zuverlässigkeit solcher Systeme verringert.

Die vorliegende Erfindung hat zum Ziel, einen Notkühlbetrieb für ein aktives Belüftungs- und Klimatisierungssystem bei Ausfall der aktiven Kühlfunktion, insbesondere durch Stromausfall, bereitzustellen. Insbesondere soll die bisherige Karenzzeit verlängert werden. Das System soll zuverlässig arbeiten und einfach zu installieren und zu warten sein.

Zu diesem Zweck schlägt die Erfindung ein Belüftungs- und Klimatisierungssystem vor, das die Merkmale des Anspruches 1 aufweist.

Die Grundidee ist eine passive Umschaltung von aktiver Raumkühlung auf passive Raumkühlung mit Hilfe von Wärmespeicherelementen. Es erfolgt eine passive Umschaltung von einem Zwangskühlbetrieb, bei dem die Wärmespeicherelemente innerhalb des Gehäuses gekühlt werden, auf einen natürlichen Konvektionskühlbetrieb, bei dem die zuvor gekühlten Wärmespeicherelemente Kühlleistung für den natürlichen Konvektionsluftstrom bereitstellen. Außerdem, erfolgt diese Umschaltung ohne zusätzliche Maßnahmen oder zusätzliche Komponenten, was die Robustheit, und somit die Zuverlässigkeit, des Systems erhöht.

Vorteilhafte Ausgestaltungen sind in den Unteransprüchen sowie in der Beschreibung angegeben.

Die vorliegende Erfindung betrifft ebenfalls ein Gebäude, welches einen Raum umfasst, wobei der Raum eine Wärmequelle und ein Belüftungs- und Klimatisierungssystem wie vorstehend beschrieben umfasst.

Die Erfindung wird anhand der folgenden Beschreibung eines Ausführungsbeispiels erläutert, das Bezug auf die angehängten Zeichnungen nimmt.

Bevorzugte Ausführungsformen der Erfindung werden nun anhand der Zeichnungen im Detail beschrieben, wobei:
- Figur 1 zeigt eine Draufsicht auf einen Raum, der eine Reihe von elektrischen oder elektronischen Regelungs- und Steuerungskomponenten enthält, die im Betrieb Wärme erzeugen.
- Figur 2 zeigt eine seitliche Schnittansicht des Raums entlang der in Figur 1 angedeuteten Schnittlinie II-II in dem ein erfindungsgemäßes Belüftungs- und Klimatisierungssystem installiert ist und in dem ein aktiver Normalkühlbetrieb durch Pfeile, die den Luftstrom anzeigen, visualisiert wird.
- Figur 3 zeigt die seitliche Schnittansicht von Figur 2, in der ein passiver Notkühlbetrieb visualisiert ist.
- Figur 4 zeigt eine detailliertere Schnittansicht eines in Figur 2 und Figur 3 dargestellten Belüftungs- und Klimatisierungssystems.

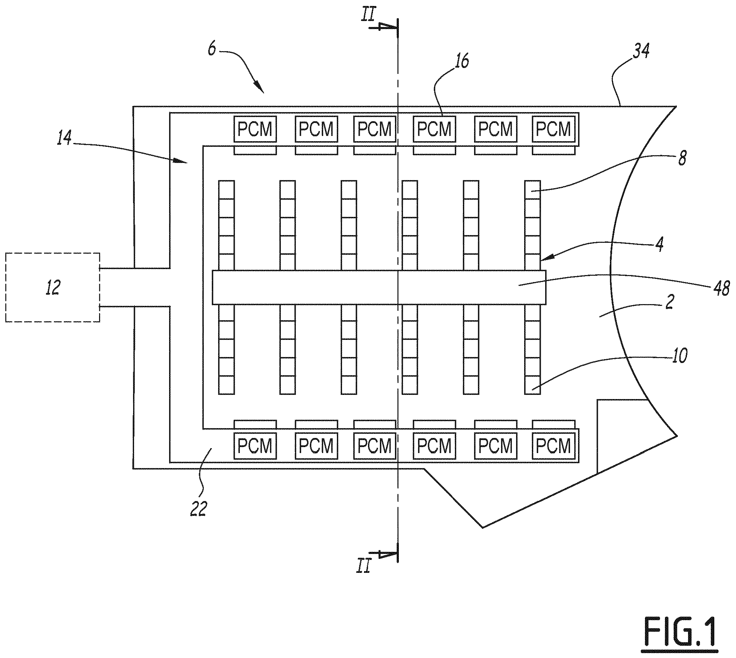

Figur 1 zeigt eine Draufsicht auf einen Raum 2, der eine Wärmequelle 4 und ein Belüftungs- und Klimatisierungssystem 6 enthält.

Der Raum 2 ist insbesondere ein Technikraum in einem Kernkraftwerk.

Die Wärmequelle 4 umfasst mehrere elektrische und elektronische Komponenten 8, insbesondere Regelungs- und Steuerungskomponenten, die im Betrieb Wärme erzeugen. Die Regelungs- und Steuerungskomponenten 8 sind beispielhaft in Schränken 10, zum Beispiel, in einem zentralen Bereich des Raumes 2 untergebracht.

Alternativ ist die Wärmequelle 4 von einem anderen Typ als die bisher beschriebenen elektrischen / elektronischen Komponenten.

Das Belüftungs- und Klimatisierungssystem 6 bläst während des Betriebs gekühlte Luft in den Raum 2 ein, um die Raumtemperatur unter einem akzeptablen Maximalwert zu halten.

Die Raumtemperatur soll im Dauerbetrieb zum Beispiel unter 25 °C gehalten werden.

In einigen Ausführungsformen ist zusätzlich eine Heizung integriert, wodurch sich ein kombiniertes Heizungs-, Belüftungs- und Klimatisierungssystem ergibt.

Das Belüftungs- und Klimatisierungssystem 6 umfasst ein Kühlluftzufuhrsystem 12, ein an das Kühlluftzufuhrsystem 12 angeschlossenes Zuluftkanalsystem 14 und mindestens ein Gehäuse 16, das einen Einlass 18 und einen Auslass 20 umfasst.

Das Kühlluftzufuhrsystem 12 umfasst beispielsweise einen Luftkühler, der zum Beispiel durch eine Kältemaschine mit Dampfkompressionskreislauf oder mit thermoelektrischer Kühlung, und einen Ventilator oder ein Gebläse zur Erzeugung eines Zwangsstroms gekühlter Luft durch das Zuluftkanalsystem 14.

Das Kühlluftzufuhrsystem 12 erzeugt zum Beispiel gekühlte Luft mit einer Temperatur zwischen 15 und 20°C.

Das in Figur 1 nur schematisch angedeutete Kühlluftzufuhrsystem 12 ist zum Beispiel außerhalb des Raumes 2 angeordnet.

Während des Betriebs des Kühlluftzufuhrsystems 12 erfolgt einen Zwangsstrom gekühlter Luft von dem Kühlluftzufuhrsystem 12 durch das Zuluftkanalsystem 14.

Das Zuluftkanalsystem 14 ist so konfiguriert, dass es während des Betriebs des Kühlluftzufuhrsystems 12 den Zwangsstrom gekühlter Luft von dem Kühlluftzufuhrsystem 12 zum Einlass 18 des Gehäuses 16 leitet.

In dem in Figur 1 gezeigten Ausführungsbeispiel umfasst das Belüftungs- und Klimatisierungssystem 6 mehrere Gehäuse 16, welche vorzugsweise in paralleler Anordnung angeordnet sind.

Wie in Figur 1 gezeigt, sind die Gehäuse 16 vorzugsweise in einer Reihe und vorzugsweise an einer Wand 34 des Raumes 2 angeordnet.

Die Gehäuse 16 sind beispielhaft in zwei parallelen Reihen an zwei gegenüberliegenden Wänden 34 des Raumes 2 angeordnet.

Alternativ sind die Gehäuse 16 in der Mitte des Raumes 2 und insbesondere zwischen den verschiedenen Komponenten 8 angeordnet.

Das Zuluftkanalsystem 14 umfasst entsprechende Abzweigungen zu jedem dieser Gehäuse 16.

Das Zuluftkanalsystem 14 umfasst mindestens einen Luftkanal 22.

Bevorzugt ist der Luftkanal 22 ein Luftschlauch aus textilem Material. Unter textilem Material versteht man beispielsweise ein Textilgewebe, insbesondere ein Textilgewebe aus Polyester. Ein solches Textilgewebe aus Polyester bietet eine gute Beständigkeit gegen Umwelt- und chemische Einflüsse und ist leicht wasch- bzw. reinigbar.

Alternativ kann auch ein metallischer Luftkanal 22 verwendet werden.

Der Luftkanal 22 leitet den Zwangsstrom gekühlter Luft von dem Kühlluftzufuhrsystem 12 zu jedem der Gehäuse 16.

Zu diesem Zweck umfasst der Luftkanal 22 beispielsweise einen Abzweig für jede Reihe von Gehäusen 16.

Alternativ umfasst das Zuluftkanalsystem 14 mehrere Luftkanäle 22, zum Beispiel einen Luftkanal 22 für jede Reihe von Gehäusen 16.

Falls der Luftkanal 22 ein Luftschlauch aus textilem Material ist, hat der Luftschlauch 22 vorzugsweise einen kreisförmigen Querschnitt wie in den Figuren dargestellt. Ein solcher Querschnitt gewährleistet eine gleichmäßige Luftverteilung. Alternativ hat der Luftschlauch 22 einen halbkreisförmigen Querschnitt.

Der Luftschlauch 22 hat beispielsweise einen Durchmesser von zwischen 300 mm und 800 mm.

Der Luftschlauch 22 ist vorzugsweise vollflächig durchlässig. Das bedeutet, dass ein Teil des Zwangsstroms gekühlter Luft an jeder Stelle des Luftschlauchs 22 ausströmen kann. Das Zuluftkanalsystem 14 umfasst vorzugsweise unterstützende Öffnungen 24, die während des Betriebs des Kühlluftzufuhrsystems 12 den Zwangsstrom gekühlter Luft aus dem Kühlluftzufuhrsystem 12 zum Einlass 18 eines jeweiligen Gehäuses 16 leiten.

Vorzugsweise ist mindestens eine Öffnung 24 gegenüber dem Einlass 18 jedes Gehäuses 16 angeordnet.

Falls der Luftkanal 22 ein Luftschlauch aus textilem Material ist, werden die Öffnungen 24 vorzugsweise durch Düsen gebildet. Diese Düsen 24 befinden sich bevorzugt an der Unterseite des Luftschlauchs 22. Jede Düse 24 richtet einen Strom gekühlter Luft auf den Einlass 18 eines der Gehäuse 16. Es handelt sich dabei beispielsweise um Vollkegeldüse, die einen Kegel gekühlter Luft auf den jeweiligen Einlass 18 richtet, oder auch kegellose Düsen, oder in den Luftschlauch gestanzte Öffnungsdüsen.

Die Düsen 24 unterstützen die Strömung, indem sie den Zwangsstrom gekühlter Luft zum Einlass 18 eines jeweiligen Gehäuses 16 richten.

Falls der Luftkanal 22 ein metallischer Luftkanal ist, können die Öffnungen 24 durch Düsen oder Ausblasgitter gebildet werden. In diesem Fall, sind die Öffnungen 24 bevorzugt die einzigen Luftauslässe aus dem Luftkanal 22 für den Zwangsstrom gekühlter Luft.

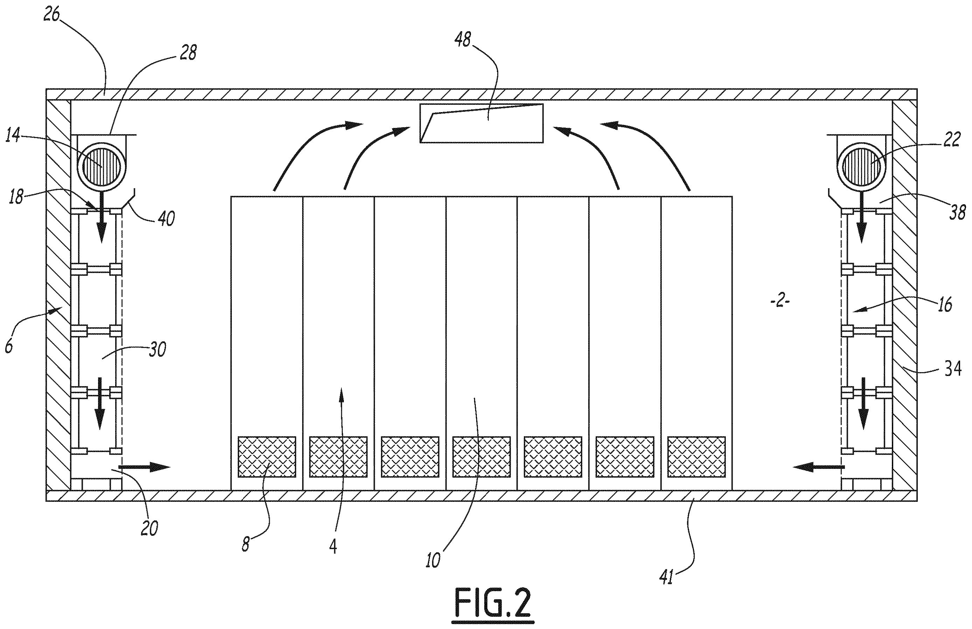

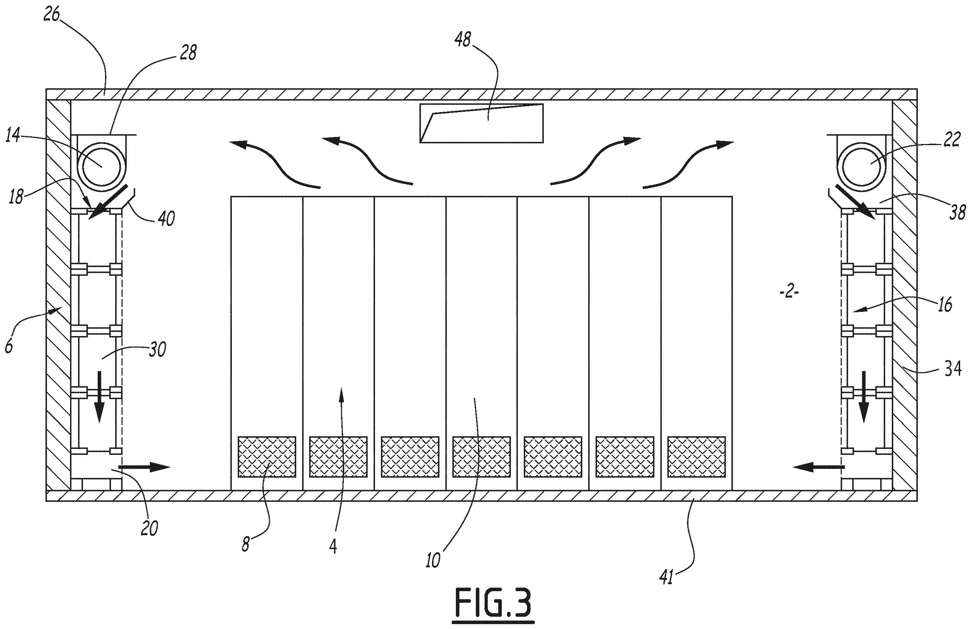

Wie in den Figuren 2 und 3 gezeigt ist das Zuluftkanalsystem 14 vorteilhafterweise in der Nähe einer Decke 26 des Raumes 2 angeordnet, zum Beispiel in einem Abstand von höchstens 20 cm zur Decke 26.

Zu diesem Zweck umfasst das Belüftungs- und Klimatisierungssystem 6 eine Halterung 28 zur Aufhängung des Zuluftkanalsystems 14 an der Decke 26 des Raumes 2.

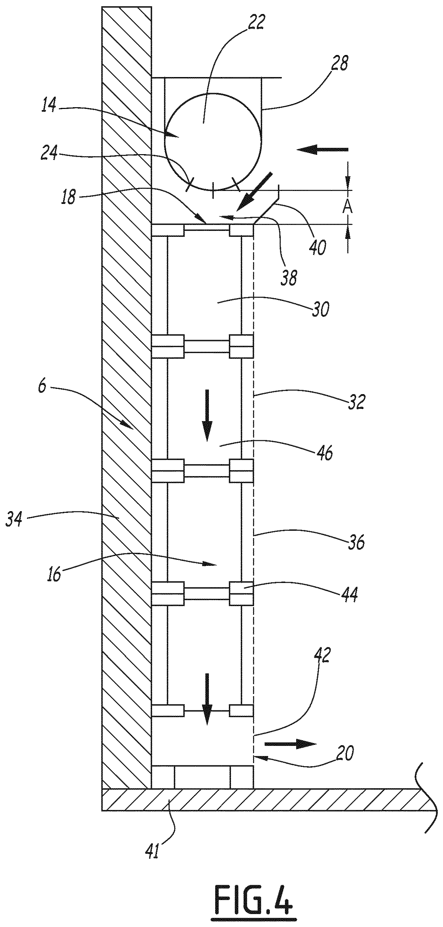

Die Halterung 28 umfasst, zum Beispiel, eine Seilaufhängung, vorzugsweise, wie in Figur 4 dargestellt, eine zweiseitige Seilaufhängung. Alternativ umfasst die Halterung 28 eine Aufhängeschiene.

Alternativ umfasst jedes Gehäuse 16 eine Halterung zur Aufnahme des Zuluftkanalsystems 14. In diesem Fall benötigt das Zuluftkanalsystem 14 keine separate Aufhängung zur Decke 26.

Jedes Gehäuse 16 umfasst Wärmespeicherelemente 30, die innerhalb des Gehäuses 16 zwischen dem Einlass 18 und dem Auslass 20 angeordnet sind. Da jedes Gehäuse 16 im Wesentlichen identisch ist, wird im Folgenden nur ein Gehäuse 16 mit Bezug auf Figur 4 beschrieben.

Das Gehäuse 16 besteht vorzugsweise aus einem geradlinigen, vertikal ausgerichteten Abschnitt, der im Kühlbetrieb einen nach unten gerichteten Luftstrom leitet.

Das Gehäuse 16 umfasst Seitenwände 32 (zum Raum gerichtet und wandseitig), die sich vertikal zwischen dem Einlass 18 und dem Auslass 20 erstrecken.

In dem in den Figuren dargestellten Beispiel steht eine der Seitenwände 32 an der Wand 34 des Raumes 2.

Das Gehäuse 16 umfasst Lochblechpaneele 36, die mindestens eine Seitenwand 32 des Gehäuses 16 bilden, und insbesondere die Seitenwand 32 des Gehäuses 16 bilden, die entfernt von der Wand 34 des Raumes 2 angeordnet ist.

Diese Lochblechpaneele 36 definieren Zugangstüren zum Gehäuse 16, zum Beispiel für Wartungsarbeiten.

Die Lochblechpaneelen 36 sind mit ihrem Lochbild so dimensioniert, dass die Wärmespeicherelemente 30 im Gehäuse 16 bei Ausfall des aktiven Kühlluftstroms auch einen Teil direkte Wärmestrahlung aufnehmen können.

Der Einlass 18 befindet sich an dem oberen Ende des Gehäuses 16, insbesondere unter dem Zuluftkanalsystem 14.

Das Zuluftkanalsystem 14 ist oberhalb des Einlasses 18 in einem Abstand A zu diesem angeordnet, wobei ein Spalt 38 zwischen dem Zuluftkanalsystem 14 und dem Einlass 18 definiert ist. Der Abstand A wird entlang der vertikalen Richtung gemessen.

Dank diesem Abstand A steht der Einlass 18 des Gehäuses 16 ständig in Strömungsverbindung mit dem Raum 2, indem Luft aus dem Raum 2 durch den Spalt 38 in den Einlass 18 des Gehäuses 16 strömen kann.

Der Abstand A sollte so groß gewählt werden, dass genügend Luft aus dem Raum 2 zwischen dem Einlass 18 und dem Luftkanal 22 hindurchströmen kann, während er gleichzeitig klein genug gewählt wird, um sicherzustellen, dass wenig gekühlte Luft aus den Öffnungen 24 verloren geht. Das Abstand A liegt zum Beispiel zwischen 50 mm und 250 mm.

Vorteilhafterweise, wie in Figur 4 dargestellt, umfasst das Gehäuse 16 ein an einem oberen Ende des Gehäuses 16 angeordnetes Leitblech 40, das Luft aus dem Raum 2 in den Einlass 18 des Gehäuses 16 leitet. Das Leitblech 40 ist so konfiguriert, dass es Luft aus einem oberen Bereich des Raumes 2, z. B. Warmluft, zu dem Spalt 38 leitet, während es gleichzeitig verhindert, dass gekühlte Luft aus den Öffnungen 24 durch den Spalt 38 in den Raum 2 strömt. Das bedeutet, dass der Zwangsstrom gekühlter Luft aus den Öffnungen 24 fast vollständig durch den Einlass 18 in das Gehäuse 16 strömen kann.

Luft aus dem Raum 2, insbesondere erwärmte Luft im Notkühlbetrieb, wird durch das Leitblech 40 zum Einlass 18 geführt und strömt danach durch das Gehäuse 16. Dadurch entsteht auf einfache Art und Weise eine zuverlässige Notkühlung des Raumes 2 im Falle eines Ausfalls des Kühlluftzufuhrsystems 12.

Der Auslass 20 führt in den Raum 2 und bildet den Austrittspunkt der Luft aus dem Gehäuse 16. Der Auslass 20 ist, wie in Figuren gezeigt, in der Nähe eines Bodens 41 des Raumes 2 angeordnet. Der Auslass 20 umfasst beispielsweise ein Gitter 42.

Das Gehäuse 16 umfasst eine Tragstruktur 44, welche im Inneren des Gehäuses 16 angeordnet ist. Die Wärmespeicherelemente 30 sind im Inneren des Gehäuses 16 mit Hilfe der Tragstruktur 44 so angeordnet, dass sie im Normalbetrieb von dem durch das Kühlluftzufuhrsystem 12 bereitgestellten Zwangsstrom gekühlter Luft überströmt werden.

Durch die Wärmespeicherelemente 30 entsteht zwar ein gewisser Druckabfall, aber der verbleibende Freiraum zwischen den Wärmespeicherelementen 30 und/oder zwischen den Wärmespeicherelementen 30 und die Seitenwände 32 des Gehäuses 16 sorgt dafür, dass der Luftstrom zwischen dem Einlass 18 und dem Auslass 20 nicht blockiert wird.

Vorzugsweise weisen die Wärmespeicherelemente 30 eine Plattenform auf, insbesondere mit flachen Seiten, die parallel Hauptströmungsrichtung ausgerichtet sind.

Gemäß einer Ausführungsform sind mehrere Wärmespeicherelemente 30 parallel und/oder hintereinander in Bezug auf die Strömungsrichtung im Inneren des Gehäuses 16 angeordnet.

Die Wärmespeicherelemente 30 bestehen vorzugsweise aus einem Phasenwechselmaterial (PCM) 46.

Das PCM 46 der Wärmespeicherelemente 30 ist vorzugsweise so gewählt, dass es bei Kontakt mit dem Zwangsstrom gekühlter Luft des Kühlluftzufuhrsystems 12, der typischerweise eine Temperatur im Bereich von 16 °C bis 30 °C hat, einfriert.

Das PCM 46 ist auch so gewählt, dass es einen Phasenwechsel von fest zu flüssig im Temperaturbereich von 16 °C bis 30°C ausführt.

Anders gesagt, schmilzt das PCM 46 vorzugsweise bei natürlicher Konvektion mit einer Schmelztemperatur im Bereich von 16 °C bis 30 °C.

Bei diesem Gefrieren / Schmelzen ist die Hysterese zu berücksichtigen.

Das PCM 46 basiert vorzugsweise auf Salzhydraten, da Salzhydrate nicht oder zumindest schwer entflammbar sind. Außerdem weisen Salzhydrate keinen Memory-Effekt auf, der ihre Wärmespeicherfähigkeit bei mehreren Gefrier- und Schmelzzyklen negativ beeinflusst. Salzhydrate haben außerdem eine hohe volumetrische Latentwärmespeicherkapazität.

Alternativ basiert das PCM 46 auf Paraffinen.

Es folgt nun die Beschreibung des Normalkühlbetriebs des Belüftungs- und Klimatisierungssystems 6, d. h. während des Betriebs des Kühlluftzufuhrsystems 12, mit Bezug auf Figur 2.

In Figur 2 ist der Luftstrom durch die Gehäuse 16 und durch den Raum 2 durch entsprechende Pfeile schematisch gezeigt.

Das Kühlluftzufuhrsystem 12 erzeugt einen Zwangsstrom gekühlter Luft. Dieser Zwangsstrom gekühlter Luft wird dann durch das Zuluftkanalsystem 14 verteilt. Das Zuluftkanalsystem 14, und insbesondere die unterstützenden Öffnungen 24 im Luftkanal 22, leiten den Zwangsstrom gekühlter Luft von der Kühlluftzufuhr zum Einlass 18 des Gehäuses oder der Gehäuse 16. Der Zwangsstrom gekühlter Luft fließt dann durch das oder die Gehäuse 16, und kühlt somit im Normalkühlbetrieb die Wärmespeicherelemente 30 ab, friert sie ein und bereitet sie für einen anschließenden etwaigen Notkühlbetrieb vor.

Im Normalkühlbetrieb werden die Wärmespeicherelemente 30 ständig gekühlt, und können dadurch Kälte speichern.

Vorzugsweise wird aus Sicherheitsgründen die Temperatur vor und nach den Wärmespeicherelementen 30 gemessen, um daraus deren Wärmespeicherkapazität abzuleiten.

Nach dem Durchfluss durch die Wärmespeicherelemente 30 tritt die gekühlte Luft am jeweiligen Auslass 20 aus dem oder jedem Gehäuse 16 aus und wird dann durch natürlichen Luftstrom im Boden an die Schränke 10 verteilt. Aufgrund der höheren Dichte der gekühlten Luft hält sich der Luftstrom auf einem niedrigen Raumniveau, insbesondere in der Nähe des Bodens.

Die Luft im Raum wird durch die Wärmeabgabe der Komponenten 8 erwärmt und steigt in Richtung der Raumdecke auf. Die erwärmte Luft wird dann durch ein Abluftsystem 48 unter der Decke 26 aus dem Raum 2 abgeführt.

Im Normalkühlbetrieb wird die erwärmte Luft daher fast ausschließlich durch das Abluftsystem 48 des Raumes 2 abgeführt und es tritt nur eine vernachlässigbare Menge an erwärmter Luft durch den jeweiligen Einlass 18 in das oder jedes Gehäuse 16 ein.

Wie oben beschrieben, ist das Belüftungs- und Klimatisierungssystem 6 so konfiguriert, dass während des Betriebs des Kühlluftzufuhrsystems 12 ein Zwangsstrom gekühlter Luft von dem Kühlluftzufuhrsystems 12 durch das Zuluftkanalsystem 14 und dann durch das oder die Gehäuse 16 vom jeweiligen Einlass 18 zum jeweiligen Auslass 20 erfolgt, wodurch die Wärmespeicherelemente 30 gekühlt und vorzugsweise eingefroren werden.

Es folgt nun die Beschreibung des Notkühlbetriebs des Belüftungs- und Klimatisierungssystems 6, d. h. wenn der Betrieb des Kühlluftzufuhrsystems ausfällt, mit Bezug auf die Figuren 3 und 4.

Fällt das Kühlluftzufuhrsystem 12 z. B. aufgrund eines Stromausfalls aus, erzeugen das Kühlluftzufuhrsystem 12 und das Abluftsystem 48 keinen Zwangsstrom gekühlter Luft, und es fließt daher keine gekühlte Luft vom Zuluftkanalsystem 14 in den Einlass 18 des Gehäuses oder der Gehäuse 16. In diesem Fall können die Temperaturen im Raum 2 und zwischen den Komponenten 8 relativ schnell einen kritischen Wert überschreiten.

Der passive Notkühlbetrieb ist in Figur 3 durch Pfeile, die die Strömungsrichtung angeben, schematisch gezeigt.

Erwärmte Luft mit einer Temperatur im Bereich von z. B. 24 °C bis 52 °C steigt an die Raumdecke auf und tritt durch Konvektion aufgrund des Temperaturunterschiedes zu dem gekühlten Inneren des Gehäuses oder die Gehäuse 16, über den jeweiligen Einlass 18 als natürlicher Konvektionsluftstrom in das oder jedes gekühlte Gehäuse 16 ein. Die erwärmte Luft strömt dann durch das oder die Gehäuse 16, und insbesondere durch die Wärmspeicherelemente 30, und kühlt sich ab.

Die Umschaltung von Zwangsstrom auf natürlichen Luftstrom erfolgt somit ohne zusätzliche aktive oder passive Funktion.

Während des passiven Kühlvorgangs wird das PCM 46 der Wärmespeicherelemente 30 durch den durchströmenden Warmluftstrom erwärmt und ändert dabei seinen Zustand von fest zu flüssig (Schmelzen). Durch den Phasenwechsel des PCM 46 und die damit verbundene latente Wärme kann eine relativ große Wärmespeicherkapazität erreicht werden. Die Wärmespeicherelemente 30 wirken somit als Latentwärmespeicher und stellen Kühlleistung für den natürlichen Konvektionsluftstrom zur Verfügung. Somit wird die Temperatur des PCM 46 bis zum vollständigen Aufschmelzen annähernd konstant gehalten.

Wie beim Normalkühlbetrieb tritt die gekühlte Luft am jeweiligen Auslass 20 im Bodenbereich das oder jedes Gehäuse 16 aus und wird durch natürlichen Luftstrom auf die wärmeerzeugenden Komponenten 8 verteilt, um diese abzukühlen.

Auf diese Weise wird ein natürlicher Konvektionsluftstrom durch den Raum 2 und durch das oder die Gehäuse 16 aufgebaut und unterstützt, solange die Kühlleistung der Wärmespeicherelemente 30 nicht überschritten wird.

Wie oben beschrieben, ist das Belüftungs- und Klimatisierungssystem 6 so konfiguriert, dass wenn der Betrieb des Kühlluftzufuhrsystems 12 ausfällt, ein natürlicher Konvektionsluftstrom durch das oder die Gehäuse 16 vom jeweiligen Einlass 18 zum jeweiligen Auslass 20 auftritt, wobei der natürliche Konvektionsluftstrom durch Übertragung von Wärme an die Wärmespeicherelemente 30 gekühlt wird.

Falls die Kühlluftzufuhrsystem 12 wieder im Betrieb genommen wird, zum Beispiel beim Wiedereinschalten der elektrischen Leistung, stellt sich wieder ein Zwangsstrom gekühlter Luft durch das oder die Gehäuse 16 ein und die Wärmespeicherelemente 30 werden daher wieder eingefroren. Die Umschaltung von natürlichen Konvektionsluftstrom auf Zwangsstrom erfolgt ebenfalls ohne zusätzliche aktive oder passive Funktion.

Dieses Belüftungs- und Klimatisierungssystem 6 gewährleistet eine inhärent sichere Kühlung des Raums für eine bestimmte Karenzzeit, sogar bei einem Stromausfall.

Insgesamt wird dank des erfindungsgemässen Systems eine relativ lange Karenzzeit, zum Beispiel von bis zu 24 Stunden, der passiven (Not-)Kühlung nach dem Ausfall des Kühlluftzufuhrsystems 12 erreicht. Die genaue Karenzzeit hängt dabei insbesondere von der Anzahl der Wärmespeicherelemente 30, dem benutzten PCM 46 und der Geometrie des Gehäuses 16 ab.

Die Erfinder haben Versuche und numerische Berechnungen mit einem erfindungsgemäßen System angestellt, wobei das System insgesamt zwölf Gehäuse 16 umfasste und jedes Gehäuses einen Stapel von 180 Salzhydrat-PCM-Wärmespeicherelementen 30 enthielt. Dabei hatte jedes Wärmespeicherelement 30 Maße von ca. 450 x 300 x 15 mm, ein Gewicht von ca. 630 kg (inkl. Gehäuse und Grundrahmen) und eine Wärmekapazität von ca. 83000 kJ. Diese Versuche und Berechnungen haben bestätigt, dass ein solches beispielhafte System eine Gesamtkühlleistung im Bereich von ca. 1000 MJ für einen Raum von ca. 72 m² Fläche und 3,4 m Höhe mit ca. 11,5 kW Heizlast für mindestens 24 Stunden bereitstellen kann.

Darüber hinaus sorgt die passive Umschaltung von Zwangsstrom auf natürlichen Luftstrom ohne zusätzliche Geräte oder Maßnahmen für die Robustheit und damit für die Zuverlässigkeit des Belüftungs- und Klimatisierungssystems 6.

## Patentansprüche

1. - Belüftungs- und Klimatisierungssystem (6) für einen Raum (2), wobei der Raum (2) eine Wärmequelle (4) und das Belüftungs- und Klimatisierungssystem (6) enthält, wobei das Belüftungs- und Klimatisierungssystem (6) umfasst:
• ein Kühlluftzufuhrsystem (12),
• mindestens ein Gehäuse (16) umfassend:
∘ einen Einlass (18), der an einem oberen Ende des Gehäuses (16) angeordnet ist,
∘ einen Auslass (20), der dazu konfiguriert ist, in den Raum (2) zu führen, und
∘ Wärmespeicherelemente (30), die innerhalb des Gehäuses (16) zwischen dem Einlass (18) und dem Auslass (20) angeordnet sind, und
• ein an das Kühlluftzufuhrsystem (12) angeschlossenes Zuluftkanalsystem (14);
wobei das Belüftungs- und Klimatisierungssystem (6) so konfiguriert ist, dass:
• während des Betriebs des Kühlluftzufuhrsystems (12) ein Zwangsstrom gekühlter Luft von dem Kühlluftzufuhrsystem (12) durch das Zuluftkanalsystem (14) und dann durch das Gehäuse (16) vom Einlass (18) zum Auslass (20) erfolgt, wodurch die Wärmespeicherelemente (30) gekühlt und vorzugsweise eingefroren werden, und
• wenn der Betrieb des Kühlluftzufuhrsystems (12) ausfällt, ein natürlicher Konvektionsluftstrom durch das Gehäuse (16) vom Einlass (18) zum Auslass (20) auftritt, wobei der natürliche Konvektionsluftstrom durch Übertragung von Wärme an die Wärmespeicherelemente (30) gekühlt wird,
**dadurch gekennzeichnet,**
**dass** das Zuluftkanalsystem (14) oberhalb des Einlasses (18) in einem Abstand (A) zu diesem angeordnet ist, wobei ein Spalt (38) zwischen dem Zuluftkanalsystem (14) und dem Einlass (18) definiert ist,
**dass** der Einlass (18) des Gehäuses (16) dazu geeignet ist, ständig in Strömungsverbindung mit dem Raum (2) zu stehen, indem die Luft aus dem Raum (2) durch den Spalt (38) in den Einlass (18) des Gehäuses strömt.

2. Belüftungs- und Klimatisierungssystem nach Anspruch 1, wobei das Zuluftkanalsystem (14) mindestens einen Luftkanal (22), bevorzugt einen Luftschlauch aus textilem Material, umfasst.

3. Belüftungs- und Klimatisierungssystem nach Anspruch 2, wobei der Luftkanal (22) ein Luftschlauch aus textilem Material ist und einen kreisförmigen oder halbkreisförmigen Querschnitt hat.

4. Belüftungs- und Klimatisierungssystem nach einem der Ansprüche 1 bis 3, wobei das Zuluftkanalsystem (14) unterstützende Öffnungen (24) umfasst, die während des Betriebs des Kühlluftzufuhrsystems (12) den Zwangsstrom gekühlter Luft von dem Kühlluftzufuhrsystem (12) zum Einlass (18) eines jeweiligen Gehäuses (16) leiten.

5. Belüftungs- und Klimatisierungssystem nach einem der Ansprüche 1 bis 4, wobei das Belüftungs- und Klimatisierungssystem (6) mindestens eine Halterung (28) zur Aufhängung des Zuluftkanalsystems (14) an einer Decke (26) des Raumes (2) umfasst, oder jedes Gehäuse (16) eine Halterung zur Aufnahme des Zuluftkanalsystems (14) umfasst.

6. Belüftungs- und Klimatisierungssystem nach einem der Ansprüche 1 bis 5, wobei das Gehäuse (16) Lochblechpaneele (36) umfasst, die mindestens eine Seitenwand (32) des Gehäuses (16) bilden.

7. Belüftungs- und Klimatisierungssystem nach einem der Ansprüche 1 bis 6, wobei das Gehäuse (16) ein an einem oberen Ende des Gehäuses (16) angeordnetes Leitblech (40) umfasst, das dazu geeignet ist, die Luft aus dem Raum (2) in den Einlass (18) des Gehäuses (16) zu leiten.

8. Belüftungs- und Klimatisierungssystem nach einem der Ansprüche 1 bis 7, wobei die Wärmespeicherelemente (30) aus einem Phasenwechselmaterial (46) bestehen.

9. Belüftungs- und Klimatisierungssystem nach Anspruch 8, wobei das Phasenwechselmaterial (46) einen Phasenwechsel von fest zu flüssig im Temperaturbereich von 16 °C bis 30°C ausführt.

10. Belüftungs- und Klimatisierungssystem nach Anspruch 8 oder 9, wobei das Phasenwechselmaterial (46) auf Salzhydraten basiert.

11. Belüftungs- und Klimatisierungssystem nach einem der Ansprüche 1 bis 10, wobei die Wärmespeicherelemente (30) eine Plattenform aufweisen.

12. Gebäude umfassend einen Raum (2), wobei der Raum (2) eine Wärmequelle (4) und ein Belüftungs- und Klimatisierungssystem (6) nach einem der Ansprüche 1 bis 11 umfasst.

13. Gebäude nach Anspruch 12, wobei der Auslass (20) in der Nähe eines Bodens (41) des Raumes (2) angeordnet ist.

14. Gebäude nach Anspruch 12 oder 13, wobei die Wärmequelle (4) mehrere elektrische und elektronische Komponenten (8) umfasst.

## Claims

1. - A ventilation and air conditioning system (6) for a room (2), the room (2) containing a heat source (4) and the ventilation and air conditioning system (6), whereby the ventilation and air conditioning system (6) comprises:
• a cooling air supply system (12),
• comprising at least one enclosure (16):
o an inlet (18) located at an upper end of the enclosure (16),
o an outlet (20) configured to lead into the room (2), and
o Heat storage elements (30) arranged within the enclosure (16) between the inlet (18) and the outlet (20), and
• a supply air duct system (14) connected to the cooling air supply system (12);
wherein the ventilation and air conditioning system (6) is configured such that:
• during operation of the cooling air supply system (12), there is a forced flow of cooled air from the cooling air supply system (12) through the supply air duct system (14) and then through the enclosure (16) from the inlet (18) to the outlet (20), thereby cooling and preferably freezing the heat storage elements (30), and
• when the operation of the cooling air supply system (12) fails, a natural convection air flow occurs through the enclosure (16) from the inlet (18) to the outlet (20), the natural convection air flow being cooled by transfer of heat to the heat storage elements (30),
**characterised in that**
the supply air duct system (14) is arranged above the inlet (18) at a distance (A) from the latter, a gap (38) being defined between the supply air duct system (14) and the inlet (18),
the inlet (18) of the enclosure (16) is adapted to be in constant flow connection with the room (2) by air flowing from the room (2) through the gap (38) into the inlet (18) of the enclosure.

2. Ventilation and air conditioning system according to claim 1, wherein the supply air duct system (14) comprises at least one air duct (22), preferably an air hose made of textile material.

3. Ventilation and air conditioning system according to claim 2, wherein the air duct (22) is an air hose made of textile material and has a circular or semicircular cross-section.

4. A ventilation and air conditioning system according to any one of claims 1 to 3, wherein the supply air duct system (14) comprises supporting openings (24) which, during operation of the cooling air supply system (12), direct the forced flow of cooled air from the cooling air supply system (12) to the inlet (18) of a respective enclosure (16).

5. A ventilation and air conditioning system according to any one of claims 1 to 4, wherein the ventilation and air conditioning system (6) comprises at least one bracket (28) for suspending the supply air duct system (14) from a ceiling (26) of the room (2), or each enclosure (16) comprises a bracket for receiving the supply air duct system (14).

6. A ventilation and air conditioning system according to any one of claims 1 to 5, wherein the enclosure (16) comprises perforated metal panels (36) forming at least one side wall (32) of the enclosure (16).

7. A ventilation and air conditioning system according to any one of claims 1 to 6, wherein the enclosure (16) comprises a baffle (40) arranged at an upper end of the enclosure (16) and adapted to direct the air from the room (2) into the inlet (18) of the enclosure (16).

8. A ventilation and air conditioning system according to any one of claims 1 to 7, wherein the heat storage elements (30) are made of a phase change material (46).

9. The ventilation and air conditioning system of claim 8, wherein the phase change material (46) performs a phase change from solid to liquid in the temperature range of 16 °C to 30 °C.

10. Ventilation and air conditioning system according to claim 8 or 9, wherein the phase change material (46) is based on salt hydrates.

11. A ventilation and air conditioning system according to any one of claims 1 to 10, wherein the heat storage elements (30) have a plate shape.

12. A building comprising a room (2), the room (2) comprising a heat source (4) and a ventilation and air conditioning system (6) according to any one of claims 1 to 11.

13. The building according to claim 12, wherein the outlet (20) is located near a floor (41) of the room (2).

14. A building according to claim 12 or 13, wherein the heat source (4) comprises multiple electrical and electronic components (8).

## Revendications

1. - Système de ventilation et de climatisation (6) pour une pièce (2), dans lequel la pièce (2) contient une source de chaleur (4) et le système de ventilation et de climatisation (6), dans lequel le système de ventilation et de climatisation (6) comprend :
• un système d'alimentation en air de refroidissement (12),
• au moins un boîtier (16) comprenant :
o une entrée (18) qui est disposée à une extrémité supérieure du boîtier (16),
o une sortie (20) qui est configurée pour déboucher dans la pièce (2), et
o des éléments d'accumulation de chaleur (30) qui sont disposés à l'intérieur du boîtier (16) entre l'entrée (18) et la sortie (20), et
• un système de conduit d'air frais (12) raccordé au système d'alimentation en air de refroidissement (14) ;
dans lequel le système de ventilation et de climatisation (6) est configuré de telle sorte que :
• pendant le fonctionnement du système d'alimentation en air de refroidissement (12), un écoulement forcé d'air refroidi est effectué depuis le système d'alimentation en air de refroidissement (12) à travers le système de conduit d'air frais (14) et ensuite à travers le boîtier (16) depuis l'entrée (18) vers la sortie (20), refroidissant et de préférence gelant ainsi les éléments d'accumulation de chaleur (30), et
• lorsque le fonctionnement du système d'alimentation en air de refroidissement (12) est défaillant, un écoulement d'air de convection naturelle se produit à travers le boîtier (16) depuis l'entrée (18) vers la sortie (20), dans lequel l'écoulement d'air de convection naturelle est refroidi par transfert de chaleur aux éléments d'accumulation de chaleur (30),
**caractérisé en ce**
**que** le système de conduit d'air frais (14) est disposé au-dessus de l'entrée (18) à une distance (A) de celle-ci, dans lequel une fente (38) est définie entre le système de conduit d'air frais (14) et l'entrée (18),
**que** l'entrée (18) du boîtier (16) est adaptée pour être constamment en liaison fluidique avec la pièce (2), du fait que l'air s'écoule depuis la pièce (2) à travers la fente (38) dans l'entrée (18) du boîtier.

2. Système de ventilation et de climatisation selon la revendication 1, dans lequel le système de conduit d'air frais (14) comprend au moins un conduit d'air (22), de préférence un tuyau d'air en matériau textile.

3. Système de ventilation et de climatisation selon la revendication 2, dans lequel le conduit d'air (22) est un tuyau d'air en matériau textile et présente une section transversale circulaire ou semi-circulaire.

4. Système de ventilation et de climatisation selon l'une quelconque des revendications 1 à 3, dans lequel le système de conduit d'air frais (14) comprend des ouvertures d'assistance (24) qui, pendant le fonctionnement du système d'alimentation en air de refroidissement (12), dirigent l'écoulement forcé d'air refroidi depuis le système d'alimentation en air de refroidissement (12) vers l'entrée (18) d'un boîtier (16) respectif.

5. Système de ventilation et de climatisation selon l'une quelconque des revendications 1 à 4, dans lequel le système de ventilation et de climatisation (6) comprend au moins un élément de retenue (28) pour suspendre le système de conduit d'air frais (14) à un plafond (26) de la pièce (2), ou chaque boîtier (16) comprend un élément de retenue pour recevoir le système de conduit d'air frais (14).

6. Système de ventilation et de climatisation selon l'une quelconque des revendications 1 à 5, dans lequel le boîtier (16) comprend des panneaux en tôle perforée (36) qui forment au moins une paroi latérale (32) du boîtier (16).

7. Système de ventilation et de climatisation selon l'une quelconque des revendications 1 à 6, dans lequel le boîtier (16) comprend un déflecteur (40) disposé à une extrémité supérieure du boîtier (16), qui est adapté pour diriger l'air depuis la pièce (2) dans l'entrée (18) du boîtier (16).

8. Système de ventilation et de climatisation selon l'une quelconque des revendications 1 à 7, dans lequel les éléments d'accumulation de chaleur (30) sont constitués d'un matériau à changement de phase (46).

9. Système de ventilation et de climatisation selon la revendication 8, dans lequel le matériau à changement de phase (46) réalise un changement de phase de solide à liquide dans la plage de température de 16 °C à 30 °C.

10. Système de ventilation et de climatisation selon la revendication 8 ou 9, dans lequel le matériau à changement de phase (46) est à base d'hydrates de sel.

11. Système de ventilation et de climatisation selon l'une quelconque des revendications 1 à 10, dans lequel les éléments d'accumulation de chaleur (30) ont une forme de plaque.

12. Bâtiment comprenant une pièce (2), dans lequel la pièce (2) comprend une source de chaleur (4) et un système de ventilation et de climatisation (6) selon l'une quelconque des revendications 1 à 11.

13. Bâtiment selon la revendication 12, dans lequel la sortie (20) est disposée à proximité d'un sol (41) de la pièce (2).

14. Bâtiment selon la revendication 12 ou 13, dans lequel la source de chaleur (4) comprend plusieurs composants électriques et électroniques (8).
